# EUROPÄISCHE PATENTSCHRIFT

(11) **EP 1 367 443 B1**
(45) Veröffentlichungstag und Bekanntmachung des Hinweises auf die Patenterteilung: **30.12.2009**
(21) Anmeldenummer: 03011418.5
(22) Anmeldetag: 20.05.2003
(51) Int. Cl.: G03F 7/20, G03B 27/20

(54) **Belichtungsvorrichtung**
Exposure apparatus
Appareil d'exposition

(30) Priorität: 27.05.2002 DE 20208285 U
(43) Veröffentlichungstag der Anmeldung: 03.12.2003
(73) Patentinhaber: PRINTPROCESS GmbH, 49179 Duisburg (DE)
(72) Erfinder: Geburek, Frank, Dipl.-Ing. (FH), 31162 Bad Salzdetfurth (DE)
(74) Vertreter: Schneider, Peter Christian

(56) Entgegenhaltungen:
- EP-A- 0 618 505
- EP-A- 0 827 035
- DE-A1- 19 851 575
- US-A- 5 288 729

## Beschreibung

Die Erfindung betrifft eine Belichtungsvorrichtung, insbesondere zur Herstellung einer Leiterplatte, bei der mindestens eine Fotomaske und ein Leiterplattenrohling für eine Vorbereitung auf einen anschließenden Belichtungsvorgang über eine, mit einer in Wirkverbindung mit einem optischen Ausrichtsystem stehende Steuerung, ansteuerbare Ausrichteinheit, zueinander ausrichtbar sind und bei der die Ausrichteinheit mindestens einen Rahmen aufweist, der im Wesentlichen aus einem Grundrahmen und einem parallel zu dem Grundrahmen in einer x/y - Ebene beweglich angeordneten und für eine Aufnahme der Fotomaske vorgesehenen Glasrahmen besteht.

Bei den immer höheren Anforderungen in der Leiterplattenherstellung zum Aufbringen feinster Schaltstrukturen auf einen Leiterplattenrohling ist die Positioniergenauigkeit einer Fotovorlage der Schaltung, die sogenannte Fotomaske, relativ zu einem Leiterplattenrohling ein wichtiges Kriterium. Bei einer anschließenden Belichtung über die Fotomaske wird nach einem gängigen Verfahren beispielsweise eine auf eine kupferbeschichtete Trägerplatte aufgebrachte lichtempfindliche Schicht, der sogenannte Fotoresist, mit UV-Licht bestrahlt. Durch die Belichtung wird die Beschaffenheit des Resists derart verändert, dass die belichteten und unbelichteten Strukturen unterschiedlich mit einer Entwicklerflüssigkeit lösbar sind. In weiteren folgenden Arbeitsschritten werden dann die Leiterbahnen freigelegt.

Für den Belichtungsvorgang des Rohlings über die Maske kommen in der industriellen Leiterplattenfertigung Belichtungsautomaten zum Einsatz. Dies sind Belichtungsvorrichtungen, die eine Einlaufsektion mit einem Förderer zum fortlaufenden Einbringen der Rohlinge, eine Belichtungssektion mit einem Rahmen, der die Fotomasken jeweils aufnimmt und nach einer Ausrichtung an den Rohlingen zum Anliegen bringt und über Belichtungsmittel, beispielsweise eine UV-Lampe, einen anschließenden Belichtungsvorgang durchführt sowie eine Auslaufsektion zum Befördern der belichteten Platten in eine Ablageeinrichtung, aufweisen. Derartige Belichtungsvorrichtungen sind in verschiedenen Ausführungen bekannt und haben sich prinzipiell bewährt.

Der Rationalisierungsdruck bei den Leiterplattenherstellern führt zu dem Wunsch nach möglichst kostengünstigen und servicefreundlichen Belichtungsautomaten, die einen hohen Durchsatz an belichteten Platten ermöglichen. Dem entgegen stehen jedoch die hohen Genauigkeitsanforderungen, die dazu geführt haben, dass eine Vielzahl von aufwendigen mechanischen Führungen, Spindeln und Getrieben sowie meistens weiteren mechanischen Positionierungshilfen angeordnet sind, die über, an einem Maschinenkörper angeordnete und über Kamerasysteme und optische Positionierungshilfen angesteuerte hochpräzise Verstellmotoren, den Rahmen mit der Fotomaske relativ zu der Leiterplatte ausrichten. Insbesondere bei der Herstellung von doppelseitigen Leiterplatten ergibt sich daraus ein konstruktiv sehr aufwendiger Aufbau. Dies führt zu hohen Herstellungskosten und einer relativ hohen Störanfälligkeit bzw. einem hohen Wartungsaufwand. Zudem nimmt die Positionierung relativ viel Zeit in Anspruch, was sich ungünstig auf die Durchsatzrate auswirkt.

Aus der DE 198 51 575 A1 ist eine Vorrichtung und ein Verfahren zum Ausrichten zweier Fotomasken und eines Leiterplattenrohlings zum anschließenden Belichten bei der Herstellung doppelseitiger Leiterplatten bekannt.

Die Vorrichtung weist als ein wesentlichen Bestandteil einer Belichtungssektion eines Belichters eine Ausrichteinheit auf. Zur Aufnahme zweier Fotomasken zur beidseitigen Aufbringung von Leiterbahnstrukturen auf die Leiterplatte, sind zwei Rahmen vorgesehen, die jeweils aus einem Grundrahmen und einem Glasrahmen bestehen. Der Glasrahmen ist ein Aluminiumrahmen, in den eine thermisch gehärtete Glasplatte eingeklebt ist. Für das Festhalten der dort aufgelegten Fotomasken sind sogenannte Vakuumleisten angebracht. Der eine Grundrahmen ist als unterer Grundrahmen an einem Maschinenkörper befestigt. Zur Verstellung des Abstandes der beiden parallel angeordneten Rahmen in einer z-Achse, sind an dem unteren Grundrahmen vier Hubspindelführungen mit Kugelrollspindeln befestigt. Der Antrieb für das Zueinanderfahren der beiden Rahmen, d.h. für ein Verfahren des oberen Rahmens in Richtung des unteren Rahmens oder von dem unteren Rahmen weg, erfolgt über zwei synchronisierte Servomotoren, die gekoppelt über Zahnriemen auf je zwei Kugelrollspindeln arbeiten. Auf dem unteren Grundrahmen ist der zugehörige Glasrahmen über Kugeln in einer x/y - Ebene beweglich gelagert. Für eine Verstellung dieses Glasrahmens sind drei Servomotoren vorgesehen, die an dem unteren Grundrahmen befestigt sind. Der obere Glasrahmen ist hingegen fest zu seinem zugehörigen Grundrahmen angeordnet. Bei der Ausrichtung wird zunächst der untere Glasrahmen justiert und anschließend mit der Leiterplatte vakuumverbunden. Die dadurch gebildete Anordnung wird anschließend in Bezug auf den oberen Glasrahmen ausgerichtet. Schließlich wird die obere und untere Anordnung zueinandergefahren und durch Evakuieren zu einer sogenannten Kassette verbunden. Für die Justierung der Fotomasken zu der Leiterplatte kommt die Vorrichtung im Gegensatz zu anderen bekannten Vorrichtungen ohne separate, aufwendig zu verstellende Positionierungsstifte für die Leiterplatte aus. Dadurch wird die Mechanik des Gerätes vereinfacht.

Nachteilig bei der bekannten Vorrichtung wirkt sich aus, dass zur Verstellung des Glasrahmens über die Servomotoren zusätzlich relativ aufwendig anzubringende separate Bauteile, insbesondere Führungen, Spindeln und Lager erforderlich sind, um die Justierung des Glasrahmens mit der aufliegenden Fotomaske gegenüber der Leiterplatte zu realisieren. Außerdem ist durch die Konstruktion mit nur einem in der x/y- Ebene verstellbaren Glasrahmen eine exakte und relativ aufwendige Führung für die Verstellung in der z-Achse erforderlich.

Aufgabe der vorliegenden Erfindung ist es daher, die bekannte Vorrichtung zum Ausrichten von Fotomasken zu einem Leiterplattenrohling und zum anschließenden Belichten des Rohlings so zu verbessern, dass ihr Aufbau einfacher und kostengünstiger wird.

Diese Aufgabe wird erfindungsgemäß in Verbindung mit dem Oberbegriff des Anspruches 1 dadurch gelöst, dass der Grundrahmen und der Glasrahmen über drei, als Aktoren ausgebildete Verstelleinheiten direkt verbunden sind, und dass die Steuerung eine spezielle Software aufweist, bei der eine jeweilige Lage der Aktoren berücksichtigbar ist, so dass über eine gleichzeitige Ansteuerung der drei Aktoren, der Glasrahmen innerhalb der x/y - Ebene in einer x-Achse, einer y-Achse und einer ϕ-Drehachse, in eine durch das optische Ausrichtsystem vorgebare Position verstellbar ist.

Dadurch, dass der bewegliche Teil des Rahmens, d.h. der Glasrahmen, direkt über die Aktoren verstellbar ist, wird der Aufbau der Belichtungsvorrichtung wesentlich vereinfacht und damit kostengünstiger. Die Aktoren vereinigen alle zur Verstellung nötigen Elemente in einem Bauteil, so dass die einzelnen Verstellelemente nicht gesondert montiert und ausgerichtet werden müssen. Zum Aufbau der Belichtungsvorrichtung, auch kurz Belichter genannt, können handelsübliche kostengünstige Aktoren Verwendung finden, die als vorgefertigte komplette kompakte Bauteile zur Verfügung gestellt werden. Es ist jedoch auch möglich, nach speziellen Vorgaben gesondert angefertigte Aktoren einzusetzen. Es fallen deutlich weniger Bauteile beim Aufbau des Belichters an. Der Aufbau wird einfacher und kann in kürzerer Zeit bewerkstelligt werden, wodurch sich ein Kostenvorteil ergibt.

Die Aktoren befinden sich im Gegensatz zu den früheren Vorrichtungen, bei denen die Verstellantriebe extern an Rahmenteilen oder Maschinenkörper angebracht sind, direkt zwischen den beiden Rahmenteilen. Sie sind zwischen Grundrahmen und Glasrahmen montiert und an ihren Enden drehbar gelagert. Es sind keine zusätzlichen äußeren Lager und Führungen nötig. Dadurch wird zusätzlich eine höhere Wartungs- und Reparaturfreundlichkeit erreicht.

Bedingt durch die direkte Verbindung der Aktoren zwischen den Rahmenteilen, müssen bei einer Verstellung, bei der Verstellelemente aus- bzw. eingefahren werden, immer alle drei Aktoren gleichzeitig angesteuert werden. Zusätzlich ist die jeweilige Winkellage der Aktoren zu berücksichtigen, da sich mit der Bewegung bei jedem Aktor dessen Winkelstellung ändert. Dies wird durch eine spezielle Software gewährleistet, die in kürzester Zeit die erforderlichen Koordinaten über einen Rechenalgorithmus berechnet und der Steuerung zur Verfügung stellt. Durch diese Art der Ausrichtung ergibt sich gegenüber den herkömmlichen Verfahren, bei denen eine größere Anzahl von einzelnen aufeinanderfolgenden Arbeitsschritten erforderlich ist, ein erheblicher Zeitvorteil. Für die Positionsfeststellung von Fotomaske und Leiterplatte kann auf ein an sich bekanntes optisches System, vorzugsweise ein CCD - Kamerasystem zurückgegriffen werden, dass über optische Positionierungshilfen, beispielsweise Kreisringe auf den Fotomasken und zugeordnete Bohrungen in den Leiterplatten, auf an sich bekannte Weise, die momentane Lage der auszurichtenden Elemente und deren Abweichung von den Zielkoordinaten bei denen die optischen Positionierungshilfen zur Deckung kommen, feststellt. Anhand dieser Daten und der Winkelstellungen der Aktoren werden dann die Stellwege für die Aktoren berechnet und die Aktoren entsprechend angesteuert.

Die Ausrichteinheit mit mindestens einem, über die Aktoren verstellbaren Rahmen, ist nicht nur auf den Einsatz in Belichtungsautomaten beschränkt. Sie ist auch für sogenannte Halbautomaten, d.h. Belichter ohne automatische Einlaufsektion oder manuelle Geräte, bei denen nur einzelne, spezielle Leiterplatten zu belichten sind, geeignet. Darüber hinaus ist die Ausrichteinheit grundsätzlich nicht nur in Belichtungsvorrichtungen, sondern auch in anderen Vorrichtungen zur Herstellung und Weiterverarbeitung von Leiterplatten einsetzbar. Insbesondere ist die Ausrichteinheit auch zur Positionierung von Innenlagen und Außenlagen in Montagevorrichtungen zur Herstellung von Multilayern geeignet, bei denen mehrere belichtete Leiterplatten in einem Stapel zueinander ausgerichtet und zusammengefügt werden.

Nach einer bevorzugten Ausführungsform der Erfindung beinhalten die als Verstelleinheiten verwendeten Aktoren, jeweils einen Motorantrieb, eine Spindel, ein Getriebe und zwei Endschalter als integrierende Bestandteile.

Aktoren mit Motor, Spindel Getriebe und Endschalter sind besonders geeignet, da sie besonders kompakt aufgebaut und kostengünstig sind. Dabei überträgt das Getriebe die Antriebsbewegung des Motors auf die Verstellbewegung der Spindel. Weiterhin sind zwei Endschalter zur automatischen Begrenzung des Verfahrweges vorgesehen. Feingetriebe und Spindeln stehen mit höchster Genauigkeit zur Verfügung, so dass sich durch die Verwendung derartiger Aktoren eine sehr hohe lineare Auflösung und Verfahrweggenauigkeit erreichen lässt. Da das System deutlich kleiner baut im Vergleich zu den bisherigen Verstelleinheiten, wird auch an Bauraum gespart.

Grundsätzlich sind jedoch auch Aktoren, die auf anderen, beispielsweise elektromagnetischen, pneumatischen oder hydraulischen Funktionsprinzipien beruhen, verwendbar.

Gemäß einer weiteren bevorzugten Ausführungsform der Erfindung sind die Aktoren in einem gleichschenkligen Dreieck angeordnet.

Dadurch, dass die Aktoren in einem gleichschenkligen Dreieck angeordnet sind, ergibt sich automatisch ein mittiger Nullpunkt, der mit dem Mittelpunkt des Rahmen, bzw. der durch zwei Rahmen gebildeten Kassette, zusammenfällt. Dadurch kann bei der Ausrichtung eine noch höhere Genauigkeit erreicht werden. Weiterhin ergibt sich durch die Anordnung der Vorteil, dass auf den Rahmen ausgeübte Kräfte, beispielsweise aufgrund einer Flächenbelastung durch einseitige Evakuierung zum Zwecke der Fixierung der Fotomaske, gleichmäßig verteilt werden.

Nach einer weiteren bevorzugten Ausführungsform der Erfindung weist die Ausrichteinheit zur Herstellung einer doppelseitigen Leiterplatte ein baugleich zu dem ersten Rahmen ausgebildeten, dem ersten Rahmen gegenüberliegend angeordneten, zweiten Rahmen zur Aufnahme einer zweiten Fotomaske auf, und ist für eine Verstellung des Abstandes der beiden Rahmen in einer senkrecht zu der x/y- Ebene gelegenen z-Achse eine ansteuerbare Verstellvorrichtung angeordnet.

Bei der Vorrichtung zur Herstellung doppelseitiger Leiterplatten liegen sich die beiden auf die Glasrahmen aufgelegten und vorzugsweise durch sogenannte Vakuumleisten gehaltenen Fotomasken gegenüber und sind zu dem, zwischen den Fotomasken gelagerten Leiterplattenrohling, über die beiden verstellbaren Glasrahmen in ihrer jeweiligen x/y-Ebene ausrichtbar. Bei doppelseitigen Leiterplatten werden auf beiden Seiten Schaltungsstrukturen aufgebracht. Diese können auch, beispielsweise über Durchkontaktierungen, miteinander in Verbindung stehen. Dabei ist eine besonders hohe Genauigkeit gefordert. Dadurch, dass beide Glasrahmen über die jeweiligen Aktoren ausrichtbar sind, kann diese hohe Genauigkeit besonders zuverlässig gewährleistet werden. Die Vorrichtung ist daher besonders zur Herstellung von doppelseitigen Leiterplatten geeignet. Zudem kommt hier die zeitliche Verkürzung für das Ausrichtverfahren durch die Verringerung der Zahl der Arbeitsschritte gegenüber Vorrichtungen, die nur über einen verstellbaren Rahmen verfügen und mit aufwendigen Führungen und anderen mechanischen Verstellelementen arbeiten, besonders zum Tragen.

Über die Verstellvorrichtung können die Rahmen in der z-Achse aufeinander zu, bzw. voneinander weg gefahren werden. Dadurch kann der Leiterplattenrohling zunächst einfach in die Belichtungssektion eingefahren und auf dafür vorgesehenen Stiften abgelegt werden und die Rahmen nach dem Ausrichtverfahren zur Ausbildung einer Vakuumkassette für einen anschließenden beidseitig simultanen Belichtungsvorgang zusammengeführt werden. Insbesondere können die Fotomasken, durch eine geeignete Ansteuerung der Verstellvorrichtung in z-Richtung, genau bis zum Anliegpunkt an die beiden Seiten des Leiterplattenrohlings gebracht werden.

Gemäß einer weiteren bevorzugten Ausführungsform der Erfindung ist der zweite Rahmen oberhalb des ersten Rahmens angeordnet, und ist der zweite Rahmen über die Verstellvorrichtung in der z-Achse verstellbar.

Durch die Verstellung lediglich des zweiten, oberen Rahmen, in der z-Achse, lässt sich die Variierung des Abstandes der beiden Rahmen konstruktiv besonders einfach und kostengünstig realisieren.

In den Unteransprüchen 6 bis 9 sind bevorzugte Ausführungsformen der Verstellvorrichtung für die z-Achse beschrieben. Die Verstellvorrichtung kann pneumatisch betreibbar sein. Sie kann auch hydraulisch oder elektromotorisch betreibbar sein. Die Verstellvorrichtung kann auch mindestens einen, speziell für die z-Achse ausgebildeten Aktor, aufweisen.

Eine pneumatische Verstellung ist besonders kostengünstig, insbesondere, wenn der verwendete Belichtungsautomat ohnehin über eine Druckluftversorgung verfügt. Da die beiden Rahmen jeweils ausrichtbar sind, muss an die pneumatische Verstellung in z-Richtung keine besonders hohe Anforderung an eine exakte Führung in der z-Achse gestellt werden. Dies wirkt sich weiter kostensenkend auf die Herstellung aus. Hydraulische oder elektromotorische Verstellungen sind von Vorteil, wenn keine Druckluftversorgung vorhanden ist. Grundsätzlich ist es auch möglich die Verstellung in der z-Achse, wie diejenige in der x/y - Ebene, über Aktoren zu betreiben. Dies bietet sich an, wenn besondere Anforderungen, beispielsweise bzgl. der exakten Einhaltung eines vorgegebenen z-Achsen Verstellweges gestellt werden.

Nach einer weiteren bevorzugten Ausführungsform der Erfindung sind die Aktoren über jeweils ein Steuerungskabel, über das alle den jeweiligen Aktor betreffende Steuerungsbefehle sowie eine jeweilige elektrische Spannungsversorgung für den jeweiligen Antriebsmotor übertragbar sind, direkt mit der Steuerung verbindbar.

Dadurch, dass die Aktoren nur über jeweils ein Kabel direkt mit der Steuerung verbunden sind, müssen keine, wie sonst üblich, zusätzlichen Kabel verlegt werden. Dadurch wird eine weitere Senkung der Herstellungskosten und eine weitere Vereinfachung des Aufbaus erreicht.

Weitere Einzelheiten der Erfindung ergeben sich aus der nachfolgenden ausführlichen Beschreibung und den beigefügten Zeichnungen, in denen bevorzugte Ausführungsformen der Erfindung beispielsweise veranschaulicht sind.

In den Zeichnungen zeigen:
- Figur 1:: Eine Draufsicht eines verstellbaren Rahmens einer Ausrichteinheit einer Belichtungsvorrichtung mit drei gleichschenklig angeordneten Aktoren in einer vereinfachter Darstellung und

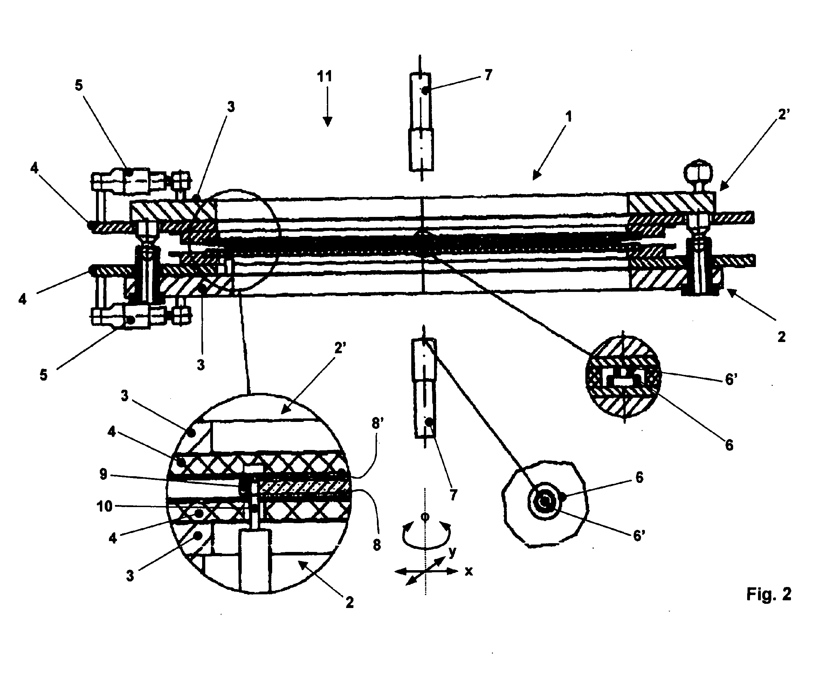

- Figur 2:: ein Ausschnitt einer Belichtungssektion der Belichtungsvorrichtung mit der Ausrichteinheit mit zwei Rahmen für eine doppelseitige Belichtung einer Leiterplatte in einer vereinfachten Darstellung in einer Seitenansicht im Schnitt.

Eine Belichtungsvorrichtung weist eine Belichtungssektion 11 mit einer Ausrichteinheit 1 auf, die im Wesentlichen aus mindestens einem Rahmen 2 mit drei Aktoren 5 besteht.

Die Belichtungsvorrichtung weist eine (nicht dargestellte) Einlaufsektion, die Belichtungssektion 11 und eine (nicht dargestellte) Auslaufsektion auf. Da der prinzipielle Aufbau derartiger Vorrichtungen bekannt ist, soll im Folgenden nur auf die für die Erfindung wesentlichen Bestandteile, insbesondere auf die Ausrichteinheit 1, detaillierter eingegangen werden.

Die in dem Ausführungsbeispiel gezeigte Belichtungsvorrichtung, auch kurz Belichter genannt, ist zur Herstellung doppelseitiger Leiterplatten ausgelegt. Dazu ist ein baugleich zu dem ersten Rahmen 2 ausgebildeter zweiter Rahmen 2' parallel gegenüberliegend angeordnet. Der Rahmen 2 bildet dann den unteren Rahmen und der Rahmen 2' entsprechend den oberen Rahmen. Die Rahmen 2, 2' sind jeweils aus einem festen Teil, dem Grundrahmen 3, und einem beweglichen Teil, dem Glasrahmen 4, aufgebaut. Beide Rahmen 2, 2' bilden, in zusammengefügtem Zustand, mit einer in dem sich bildenden Zwischenraum gelagerten Leiterplatte 9, eine sogenannte Kassette. Der Glasrahmen 3 besteht aus einer gerahmten, thermisch gehärteten Glasscheibe, auf die eine Fotomaske 8 bzw. 8' aufgelegt und über eine (nicht dargestellte) Vakuumhalterung gehalten wird. Auf der Fotomaske 8, 8', vorteilhaft über ein CAD-System hergestellt, ist die jeweilige Schaltung abgebildet, die über ein Belichtungsverfahren in der Belichtungsvorrichtung auf die Leiterplatte 9 übertragen wird. Dazu wird die Leiterplatte 9, bzw. der Leiterplattenrohling, über die (nicht dargestellte) Einlaufsektion in den Belichter eingebracht und auf dafür vorgesehenen Stiften 10 abgelegt. Die Stifte 10 stehen fest und halten die Leiterplatte 9 in fixer Position. Mit der Ausrichteinheit 1 werden die Fotomasken 8, 8' zu der Leiterplatte 9 ausgerichtet. Dazu sind auf den Fotomasken 8, 8' eine Mehrzahl optischer Positionierungshilfen 6, 6', vorteilhaft als Kreisringe verschiedenen Durchmessers, vorgesehen. In der Leiterplatte 9 sind, auf die Positionierungshilfen 6, 6' abgestimmte Bohrlöcher eingebracht. Bei der Ausrichtung der Fotomasken 8, 8' zu der Leiterplatte 9 sind die Kreisringe 6, 6' mit den Bohrlöchern zur Deckung zu bringen. Die Erfassung der aktuellen Lage der Fotomasken 8, 8' und der ggf. daraus resultierenden Abweichung von den Zielkoordinaten geschieht mit Hilfe eines an sich bekannten optischen Ausrichtsystems 7, vorteilhaft basierend auf einer Mehrzahl CCD - Kameras.

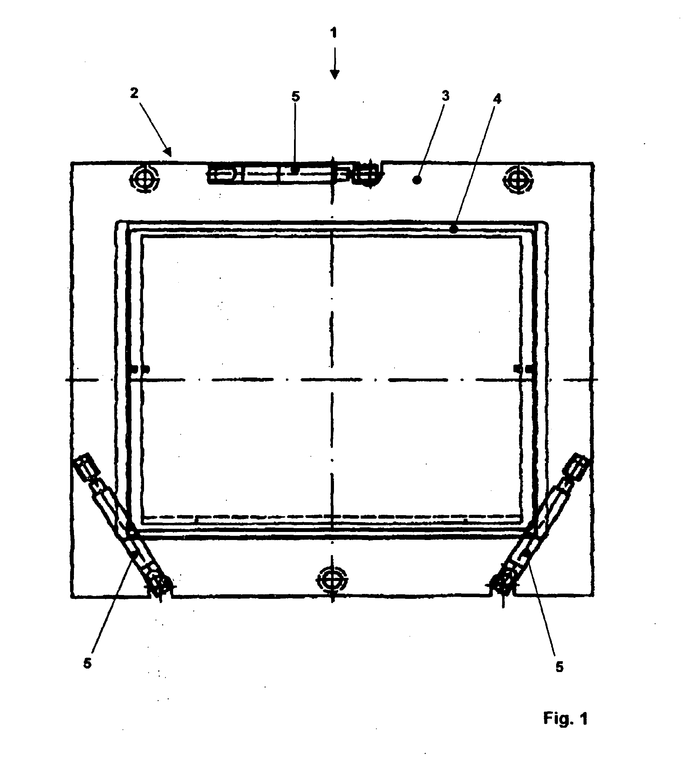

Der Grundrahmen 3 ist mit dem Glasrahmen 4 durch die drei Aktoren 5 verbunden. In den Aktoren 5 sind jeweils ein Antriebsmotor, eine Spindel ein Getriebe und zwei Endschalter integriert. Diese Bauteile sind in den Figuren nicht im Einzelnen dargestellt. Die Aktoren 5 sind mit diesen Bauteilen auf an sich bekannte Weise als komplette Verstelleinheiten ausgebildet und stehen als fertige Elemente zur Verfügung oder können nach vorgebbaren Spezifikationen angefertigt werden. Die Aktoren 5 sind jeweils mit ihrem einen Ende an dem Grundrahmen 3 und mit ihrem anderen Ende an dem Glasrahmen 4 drehbar gelagert. Über ein (nicht dargestelltes) Kabel mit einem mehrpoligen Stecker ist jeder Aktor mit einer (nicht dargestellten) Steuerung verbunden. Vorteilhaft bilden die drei Aktoren 5 ein gleichschenkliges Dreieck wie in Fig. 1 dargestellt. Über die Aktoren 5 kann der Glasrahmen 4 in einer durch den Grundrahmen 3 gebildeten x/y - Ebene verfahren werden. Eine gleichzeitige Ansteuerung der Aktoren 5 ermöglicht eine Bewegung in einer x-Achse, einer y-Achse sowie eine Drehbewegung in einer ϕ-Drehachse. Die Winkelstellung der drehbar gelagerten Aktoren 5 ändert sich bei der Bewegung des Glasrahmens 4 zwangsläufig. Aus der über das Kamerasystem 7 ermittelten Abweichung von den Deckungskoordinaten der optischen Positionierungshilfen 6, 6' und der jeweiligen Winkelstellung der Aktoren 5 wird eine Stellgröße berechnet. Entsprechend werden die Aktoren 5 bis zur Erreichung der Sollposition über die Steuerung angesteuert. Beide Glasrahmen 3 der Rahmen 2, 2' können in gleicher Weise in der, durch den Glasrahmen 4 jeweils gegebenen x/y - Ebene bewegt werden. Der obere Rahmen 2' lässt sich zudem in einer z-Achse (z-Hub) senkrecht zu der x/y - Ebene über eine (nicht dargestellte) Verstellvorrichtung verstellen.

Bei dem Ausrichtvorgang wird zunächst der zu belichtende Rohling 9 auf den Stiften 10 abgelegt, anschließend der obere Rahmen 2' nach unten verfahren (z-Hub), darauffolgend über das CCD - Kamerasystem 7 die Abweichungen der Fotomasken 8, 8' von der Sollposition ermittelt, daraus unter Berücksichtigung der Aktorenwinkel die Aktorenstellwege berechnet. Anschließend verfahren die Aktoren 5 die Masken 8, 8' um die ermittelten Beträge. Zur endgültigen Fixierung von Leiterplatte 9 und Fotomasken 8, 8' wird schließlich die Kassette evakuiert. Die dabei auftretende erhebliche äußere Belastung, typischerweise 700 - 800 kg, wird mit Hilfe der Anordnung der Aktoren in dem gleichschenkligen Dreieck gleichmäßig auf die Flächen verteilt. Die so vorbereitete Kassette ist dann für eine simultane Belichtung auf beiden der Leiterplatte 9 über ein an sich bekanntes Belichtungssystem bereit.

## Patentansprüche

1. Belichtungsvorrichtung (11), insbesondere zur Herstellung einer Leiterplatte (9), bei der mindestens eine Fotomaske (8) und ein Leiterplattenrohling für eine Vorbereitung auf einen anschließenden Belichtungsvorgang über eine, mit einer in Wirkverbindung mit einem optischen Ausrichtsystem stehende Steuerung, ansteuerbare Ausrichteinheit (1), zueinander ausrichtbar sind und bei der die Ausrichteinheit mindestens einen Rahmen (2) aufweist, der im Wesentlichen aus einem Grundrahmen (3) und einem parallel zu dem Grundrahmen in einer x/y - Ebene beweglich angeordneten und für eine Aufnahme der Fotomaske (8) vorgesehenen Glasrahmen (4) besteht, **dadurch gekennzeichnet, dass** der Grundrahmen (3) und der Glasrahmen (4) über drei, als Aktoren (5) ausgebildete Verstelleinheiten direkt verbunden sind, und dass die Steuerung eine spezielle Software aufweist, bei der eine jeweilige Lage der Aktoren (5) berücksichtigbar ist, so dass über eine gleichzeitige Ansteuerung der drei Aktoren (5), der Glasrahmen (4) innerhalb der x/y - Ebene in einer x-Achse, einer y-Achse und einer ϕ-Drehachse, in eine durch das optische Ausrichtsystem (7) vorgebare Position verstellbar ist.

2. Belichtungsvorrichtung nach Anspruch 1, **dadurch gekennzeichnet, dass** die als Verstelleinheiten verwendeten Aktoren (5), jeweils einen Motorantrieb, eine Spindel, ein Getriebe und zwei Endschalter als integrierende Bestandteile beinhalten.

3. Belichtungsvorrichtung nach Anspruch 1 oder 2, **dadurch gekennzeichnet, dass** die Aktoren (5) in einem gleichschenkligen Dreieck angeordnet sind.

4. Belichtungsvorrichtung nach einem der Ansprüche 1 bis 3, **dadurch gekennzeichnet, dass** die Ausrichteinheit (1) zur Herstellung einer doppelseitigen Leiterplatte (9) ein baugleich zu dem ersten Rahmen (2) ausgebildeten, dem ersten Rahmen (2) gegenüberliegend angeordneten, zweiten Rahmen (2') zur Aufnahme einer zweiten Fotomaske (8') aufweist, und dass für eine Verstellung des Abstandes der beiden Rahmen (2, 2') in einer senkrecht zu der x/y- Ebene gelegenen z-Achse eine ansteuerbare Verstellvorrichtung angeordnet ist.

5. Belichtungsvorrichtung nach Anspruch 4, **dadurch gekennzeichnet, dass** der zweite Rahmen (2') oberhalb des ersten Rahmens (2) angeordnet ist, und dass der zweite Rahmen (2') über die Verstellvorrichtung in der z-Achse verstellbar ist.

6. Belichtungsvorrichtung nach Anspruch 4 oder 5, **dadurch gekennzeichnet, dass** die Verstellvorrichtung für die Verstellung der Ausrichteinheit (1) in der z-Achse pneumatisch betreibbar ist.

7. Belichtungsvorrichtung nach Anspruch 4 oder 5, **dadurch gekennzeichnet, dass** die Verstellvorrichtung für die Verstellung der Ausrichteinheit (1) in der z-Achse hydraulisch betreibbar ist.

8. Belichtungsvorrichtung nach Anspruch 4 oder 5, **dadurch gekennzeichnet, dass** die Verstellvorrichtung für die Verstellung der Ausrichteinheit (1) in der z-Achse elektromotorisch betreibbar ist.

9. Belichtungsvorrichtung nach einem der Ansprüche 4 bis 8, **dadurch gekennzeichnet, dass** die Verstellvorrichtung für die Verstellung der Ausrichteinheit (1) in der z-Achse mindestens einen speziell für die z-Achse ausgebildeten Aktor aufweist.

10. Belichtungsvorrichtung nach einem der Ansprüche 1 bis 9, **dadurch gekennzeichnet, dass** die Aktoren (5) über jeweils ein Steuerungskabel, über das alle den jeweiligen Aktor (5) betreffenden Steuerungsbefehle sowie eine jeweilige elektrische Spannungsversorgung für den jeweiligen Antriebsmotor übertragbar sind, direkt mit der Steuerung verbindbar sind.

## Claims

1. Exposure apparatus (11), especially for the production of a printed circuit board (9), wherein at least one photomask (8) and one blank circuit board can be aligned with one another for preparation for a subsequent exposure process by means of an controllable aligner unit (1), via a control that operatively interacts with an optical alignment system, and wherein the aligner unit features at least one frame (2) which essentially consists of a base frame (3) and a glass frame (4) that is movably arranged in parallel to the base frame on an x/y plane and is designated for receiving the photomask (8), **characterized in that** the base frame (3) and the glass frame (4) are connected directly via three adjusting units conceived as actuators (5) and that the control features a special software wherein the respective position of the actuators (5) is taken into account so that by the simultaneous activation of the three actuators (5) the glass frame (4) can be adjusted within the x/y plane in an x-axis, a y-axis and around a rotational ϕ-axis into a position that can be specified by the optical alignment system (7).

2. Exposure apparatus according to Claim 1, **characterized in that** the actuators (5) used as adjusting units each comprise a motor drive, a spindle, a gear and two end switches as integrating components.

3. Exposure apparatus according to Claim 1 or 2, **characterized in that** the actuators (5) are housed in an isosceles triangle.

4. Exposure apparatus according to any of Claims 1 to 3, **characterized in that** the aligner unit (1) for producing a two-sided printed circuit board (9) features a second frame (2') that is identical in construction to the first frame (2) and is arranged opposite the first frame (2) and designed to receive a second photomask (8'), and **in that** there is a controllable adjusting apparatus for adjusting the distance of both frames (2, 2') in a z-axis that is perpendicular to the x/y plane.

5. Exposure apparatus according to Claim 4, **characterized in that** the second frame (2') is arranged above the first frame (2) and that the second frame (2') is adjustable in the z-axis by means of the adjusting apparatus.

6. Exposure apparatus according to Claim 4 or 5, **characterized in that** the adjusting apparatus for adjusting the aligner unit (1) in the z-axis can be operated pneumatically.

7. Exposure apparatus according to Claim 4 or 5, **characterized in that** the adjusting apparatus for adjusting the aligner unit (1) in the z-axis can be operated hydraulically.

8. Exposure apparatus according to Claim 4 or 5, **characterized in that** the adjusting apparatus for adjusting the aligner unit (1) in the z-axis can be operated by electromotive means.

9. Exposure apparatus according to any of Claims 4 to 8, **characterized in that** the adjusting apparatus for adjusting the aligner unit (1) in the z-axis features at least one actuator especially conceived for the z-axis.

10. Exposure apparatus according to any of Claims 1 to 9, **characterized in that** the actuators (5) can each be linked directly to the control via a control cable through which all control commands affecting the respective actuator (5) as well as electrical power for the respective drive motor can be transmitted.

## Revendications

1. Appareil d'exposition (11), en particulier pour réaliser une carte à circuit imprimé (9), dans lequel au moins un masque photographique (8) et une ébauche de carte peuvent, afin de préparer un processus d'exposition consécutif, être alignés l'un par rapport à l'autre au moyen d'une unité d'alignement (1) pouvant être asservie par une unité de commande se trouvant en liaison fonctionnelle avec un système d'alignement optique, et selon lequel l'unité d'alignement présente au moins un cadre (2) qui est constitué pour l'essentiel d'un cadre de base (3) et d'un cadre de verre (4) disposé au cadre de base, de manière parallèlement mobile dans un plan x/y et prévu pour recevoir le masque photographique (8), **caractérisé en ce que** le cadre de base (3) et le cadre de verre (4) sont directement reliés au moyen de trois unités de réglage réalisées sous forme d'actionneurs (5), et **en ce que** l'unité de commande présente un logiciel spécial qui tient compte de la position respective des actionneurs (5), de sorte que, par un asservissement simultané des trois actionneurs (5), le cadre de verre (4) peut être réglé dans le plan x/y sur l'axe x et l'axe y, et autour d'un axe de rotation ϕ, dans une position pouvant être prescrite par le système d'alignement optique (7).

2. Appareil d'exposition selon la revendication 1, **caractérisé en ce que** les actionneurs (5) utilisés comme unités de réglage comprennent chacun comme composants intégrés un entraînement motorisé, une broche, une transmission et deux interrupteurs de fin de course.

3. Appareil d'exposition selon la revendication 1 ou 2, **caractérisé en ce que** les actionneurs (5) sont disposés dans un triangle isocèle.

4. Appareil d'exposition selon l'une des revendications 1 à 3, **caractérisé en ce que** l'unité d'alignement (1) présente, afin de réaliser une carte à circuit imprimé (9) à double face, un deuxième cadre (2') de structure identique au premier cadre (2), disposé en vis-à-vis du premier cadre (2) et destiné à recevoir un deuxième masque photographique (8'), et **en ce qu'**un dispositif de réglage asservissable est disposé afin de régler la distance entre les deux cadres (2, 2') sur un axe z perpendiculaire au plan x/y.

5. Appareil d'exposition selon la revendication 4, **caractérisé en ce que** le deuxième cadre (2') est disposé au-dessus du premier cadre (2), et **en ce que** le deuxième cadre (2') est réglable sur l'axe z au moyen du dispositif de réglage.

6. Appareil d'exposition selon la revendication 4 ou 5, **caractérisé en ce que** le dispositif de réglage pour le réglage de l'unité d'alignement (1) sur l'axe z est à fonctionnement pneumatique.

7. Appareil d'exposition selon la revendication 4 ou 5, **caractérisé en ce que** le dispositif de réglage pour le réglage de l'unité d'alignement (1) sur l'axe z est à fonctionnement hydraulique.

8. Appareil d'exposition selon la revendication 4 ou 5, **caractérisé en ce que** le dispositif de réglage pour le réglage de l'unité d'alignement (1) sur l'axe z est à fonctionnement par moteur électrique.

9. Appareil d'exposition selon l'une des revendications 4 à 8, **caractérisé en ce que** le dispositif de réglage pour le réglage de l'unité d'alignement (1) sur l'axe z présente au moins un actionneur spécialement conçu pour l'axe z.

10. Appareil d'exposition selon l'une des revendications 1 à 9, **caractérisé en ce que** les actionneurs (5) peuvent être directement reliés à l'unité de commande au moyen d'un câble de commande respectif, par l'intermédiaire duquel tous les ordres de commande concernant l'actionneur respectif (5), ainsi qu'une alimentation respective en courant électrique pour le moteur d'entraînement respectif, peuvent être transmis.
